# EUROPÄISCHE PATENTSCHRIFT

(11) **EP 3 222 902 B1**
(45) Veröffentlichungstag und Bekanntmachung des Hinweises auf die Patenterteilung: **13.05.2020**
(21) Anmeldenummer: 17162727.6
(22) Anmeldetag: 24.03.2017
(51) Int. Cl.: F21S 8/04, F21Y 103/00, F21Y 105/10, F21Y 115/10, F21S 8/00

(54) **LED-PLATINE FÜR LEUCHTE, HERSTELLUNGSVERFAHREN FÜR EINE SOLCHE LED-PLATINE SOWIE LEUCHTE**
LED BOARD FOR A LIGHT, PROCESS FOR THE MANUFACTURE OF SUCH AN LED BOARD AND LIGHT
PLATINE À DEL POUR ÉCLAIRAGE, PROCÉDÉ DE FABRICATION POUR UNE PLATINE À DEL ET ÉCLAIRAGE

(30) Priorität: 24.03.2016 DE 102016204993
(43) Veröffentlichungstag der Anmeldung: 27.09.2017
(73) Patentinhaber: Zumtobel Lighting GmbH, 6850 Dornbirn (AT)
(72) Erfinder: Favarolo, Angelo, Dott. Ing., 88238 Wangen im Allgäu (DE); Machate, Andreas, 88239 Wangen im Allgäu (DE); Pöhs, Mario, 6850 Dornbirn (AT)
(74) Vertreter: Thun, Clemens

(56) Entgegenhaltungen:
- EP-A2- 2 280 213
- DE-A1-102009 054 840
- DE-A1-102012 108 719
- DE-U1-202014 104 797
- DE-U1-202016 000 122
- GB-A- 2 464 668

## Beschreibung

Die Erfindung betrifft eine Leuchte mit einer LED-Platine (LED: Licht emittierende Diode). Mit "Platine" sei hierbei ein Träger einer elektronischen Schaltung bezeichnet und mit "LED-Platine" eine Platine mit wenigstens einer darauf angeordneten LED.

Aus dem Stand der Technik ist es bekannt, Platinen in einem Batch-Prozess zu fertigen. Das Trägermaterial ("Nutzen") wird hierbei beschichtet, bestückt und zugeschnitten. So genannte "Endlosplatinen" (Flexstripes) werden in einem Batch-Prozess auf Folien gefertigt, zugeschnitten, an den Enden zusammengelötet, und aufgerollt zu "Endlosplatinen". Eine Beschränkung ist hierbei zum einen durch die Länge der Nutzen (600 mm) gegeben und zum anderen durch die Anlagengröße (Batch-Reaktor). Allgemein ist die Herstellung vergleichsweise kosten- und zeitintensiv.

Aus dem Stand der Technik ist weiterhin eine Leuchte mit einer LED-Platine bekannt, bei der die wenigstens eine LED eine Lichtquelle der Leuchte bildet. Die Leuchte weist ein Leuchtengehäuse auf, wobei die LED-Platine gut Wärme leitend an dem Leuchtengehäuse befestigt ist. Die Wärme leitende Verbindung ist dabei wichtig, weil bei Betrieb der Leuchte durch die LED Wärme erzeugt wird, die abtransportiert werden soll, um geeignete Betriebsbedingungen für die LED zu gewährleisten.

Zur Herstellung der Leuchte muss dementsprechend in einem Verfahrensschritt die LED-Platine gut Wärme leitend an dem Leuchtengehäuse befestigt werden. Dieser Verfahrensschritt erfordert einen signifikanten Aufwand.

Aus der DE 20 2014 104 797 U1 ist eine Leuchte mit einem Trägerelement bekannt, auf dem eine LED-Lichtquelle angeordnet ist. Das Trägerelement besteht aus einem gebogenen Blechteil.

Aus der DE 20 2016 000 122 U1 ist eine Feuchtraumleuchte mit einem, aus einer Blechplatte gebildeten Träger bekannt, auf dem Halbleiterlichtquellen in einem Modul mit Platine angebracht sind.

Ferner ist aus der DE 10 2009 054 840 A1 bekannt, eine LED-Platine formbeständig in eine von einer planaren Form abweichende profilierte Form zu biegen.

Der Erfindung liegt die Aufgabe zugrunde, eine Leuchte mit einer verbesserten LED-Platine anzugeben.

Insbesondere soll mit der LED-Platine bei guten thermischen Eigenschaften eine einfache Herstellung der Leuchte ermöglicht sein.

Diese Aufgabe wird gemäß der Erfindung mit dem in Anspruch 1 genannten Gegenstand gelöst. Besondere Ausführungsarten der Erfindung sind in den abhängigen Ansprüchen angegeben.

Gemäß der Erfindung wird eine Leuchte mit einer Platine mit wenigstens einer darauf angeordneten LED sowie einem Lichtbeeinflussungselement zur Beeinflussung eines von der wenigstens einen LED abgestrahlten Lichts vorgeschlagen,
wobei die Platine eine, aus einem Blech gebildete Lage aufweist, insbesondere aus einem Aluminiumblech, einem Stahlblech oder einem Kupferblech,
wobei die Lage einen ersten planen Bereich und einen formbeständig gebogenen Bereich aufweist,
wobei die Platine aus der Lage und wenigstens einer darauf angeordneten Schicht besteht, die zur Bildung einer Leiterbahn der Platine dient und eine Lackschicht darstellt,
und wobei die Platine derart ausgeführt ist, dass sie auf zwei gegenüberliegenden Seiten profilierte Bereiche aufweist, die einerseits der Befestigung an einer Tragschiene dienen und andererseits der Halterung des Lichtbeeinflussungselements, so dass das Lichtbeeinflussungselement an der Platine gehalten angeordnet ist.

Durch die Verwendung der Lage aus Blech ist eine besonders geeignete Herstellung der Platine ermöglicht. Beispielsweise kann hierzu ein so genanntes "Coil" bzw. "Metall-Coil", also eine Metallblechrolle, beispielsweise eine Bandstahlrolle verwendet werden; durch Abwickeln des Coils lässt sich besonders geeignet ein kontinuierlicher Herstellungsschritt realisieren. Das Coil kann hierzu beispielsweise einfach auf einer Haspel aufgespannt und dann abgerollt werden.

Dabei eignet sich die Platine durch den formbeständig gebogenen Bereich erfindungsgemäß als ein tragendes Teil der Leuchte, beispielsweise als ein Gehäuse der Leuchte. Der plane Bereich eignet sich besonders zur Verbindung mit der LED. Zudem ist durch diese Gestaltung eine besonders effektive Wärmeableitung einer von der LED erzeugten Wärme ermöglicht. Die Platine kann somit besonders geeignet als Kühlkörper der Leuchte bzw. für die LED dienen.

Erfindungsgemäß besteht die Platine aus der Lage und wenigstens einer darauf angeordneten Schicht, die zur Bildung einer Leiterbahn der Platine dient und eine Lackschicht darstellt.

Vorzugsweise ist dabei die Lage den ersten planen Bereich und den gebogenen Bereich in zusammenhängender Form bildend ausgestaltet. Hierdurch sind insbesondere eine gute Formstabilität und eine gute Ableitung einer durch die LED erzeugten Wärme ermöglicht.

Vorzugsweise weist der gebogene Bereich einen Krümmungsradius auf, der kleiner als 10 mm ist, vorzugsweise kleiner als 5 mm, wobei der gebogene Bereich insbesondere derart gestaltet ist, dass durch ihn eine Kante gebildet ist. Hierdurch lässt sich besonders geeignet eine gute Stabilität der Platine erzielen. Außerdem ist diese Gestaltung zum Beispiel vorteilhaft mit Bezug auf die Eignung der Platine als Leuchtengehäuse.

Vorzugsweise weist die Lage weiterhin einen zweiten planen Bereich auf, der mit Bezug auf den gebogenen Bereich dem ersten planen Bereich gegenüberliegend angeordnet ist, wobei der zweite plane Bereich gleich groß wie oder kleiner als der erste plane Bereich ist, jedoch mindestens so groß ist wie 10%, vorzugsweise wie 20% des ersten planen Bereichs. Durch diese Gestaltung eignet sich die Platine besonders als Gehäuse der Leuchte. Vorzugsweise begrenzen dabei der erste plane Bereich und der zweite plane Bereich einen Winkel, der größer als 40° und kleiner als 140° ist.

Vorzugsweise bildet die Platine zumindest im Wesentlichen ein profilförmiges Bauteil, durch das eine Profilachse festgelegt ist, wobei der gebogene Bereich um eine parallel zu der Profilachse orientiert Biegeachse gebogen ist. Hierdurch eignet sich die Platine insbesondere als Leuchtengehäuse einer länglichen Leuchte, beispielsweise einer so genannten "Lichtbandleuchte".

Vorzugsweise weist die Lage dabei außerdem einen weiteren formbeständig gebogenen Bereich auf, der mit Bezug auf den ersten planen Bereich dem zuerst genannten formbeständig gebogenen Bereich gegenüberliegend ausgebildet ist, wobei die wenigstens eine LED auf dem ersten planen Bereich angeordnet ist. Auf diese Weise lässt sich die Platine insbesondere besonders geeignet als schützendes Element der wenigstens einen LED gestalten.

Vorzugsweise ist dabei die Lage in einem Querschnitt normal zu der Profilachse betrachtet mit Bezug auf eine Mittelebene zumindest im Wesentlichen symmetrisch gestaltet, wobei vorzugsweise die wenigstens eine LED auf der Mittelebene liegend angeordnet ist. So eignet sich die Platine besonders als symmetrisches Leuchtengehäuse, durch das besonders geeignet eine Wärmeableitung auf zwei gegenüberliegende Seiten ermöglicht ist.

Vorzugsweise ist dabei durch einen Oberflächenbereich der Platine ein Außenflächenbereich der Leuchte gebildet. Dies ist insbesondere vorteilhaft mit Bezug auf gute thermische Eigenschaften der Leuchte zur Ableitung von Wärme, die bei Betrieb der Leuchte durch die wenigstens eine LED erzeugt wird.

Vorzugsweise ist dabei durch die Platine ein Gehäuse der Leuchte gebildet. So lässt sich eine besonders effektive Wärmeabgabe an die Umgebung der Leuchte erzielen. Außerdem ist hierdurch die Herstellung grundsätzlich erleichtert, da anstelle von zwei unterschiedlichen Bauteilen, nämlich Gehäuse und LED-Platine, lediglich ein Bauteil, nämlich die anmeldungsgemäße LED-Platine hergestellt werden muss.

Die Erfindung wird im Folgenden anhand eines Ausführungsbeispiels und mit Bezug auf die Zeichnungen näher erläutert. Es zeigen:
- Fig. 1: eine perspektivische Skizze einer anmeldungsgemäßen Leuchte mit einer anmeldungsgemäßen LED-Platine,
- Fig. 2: eine Querschnitt-Skizze der Leuchte,
- Fig. 3: eine entsprechende Querschnittskizze der LED-Platine und eines daran gehaltenen Lichtbeeinflussungselements,
- Fig. 4: eine entsprechende Querschnitt-Skizze der separierten LED-Platine und
- Figuren 5 bis 12: Skizzen zu Abläufen eines anmeldungsgemäßen Verfahrens zur Herstellung der Platine.

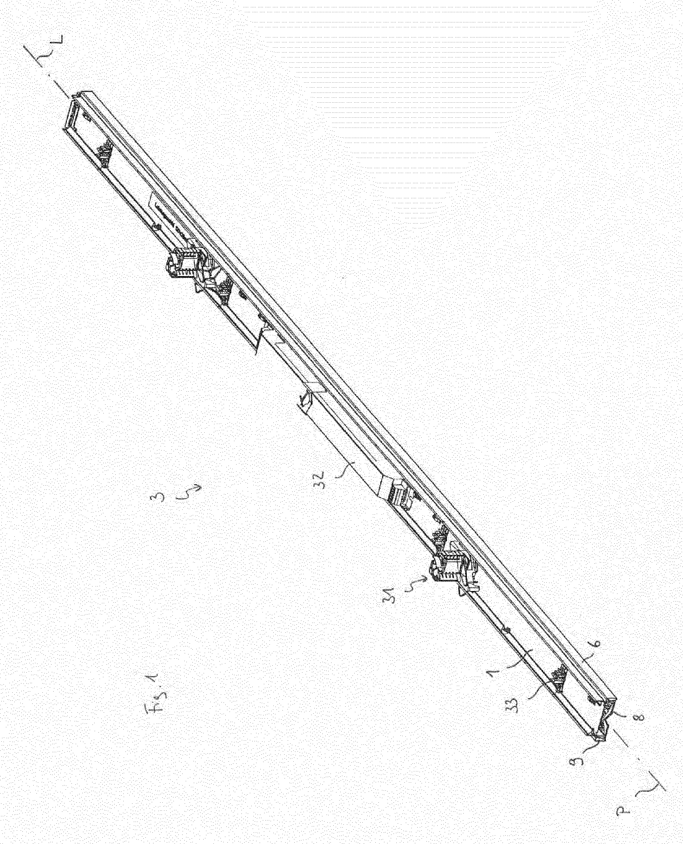

Fig. 1 zeigt eine perspektivische Skizze einer anmeldungsgemäßen Leuchte 3. Bei der Leuchte 3 kann es sich insbesondere - wie gezeigt - um eine längliche Leuchte handeln, die sich entlang einer Längsachse L erstreckt. Insbesondere kann es sich bei der Leuchte 3 um eine so genannte Balkenleuchte handeln, die zur Erzeugung eines so genannten Lichtbands vorgesehen ist und die dazu ausgestaltet ist, mechanisch und elektrisch mit einer (in den Figuren nicht gezeigten) Tragschiene verbunden zu werden. Bei dem in Fig. 1 gezeigten Beispiel weist die Leuchte 3 hierfür einen so genannten Rotationsabgriff 31 auf.

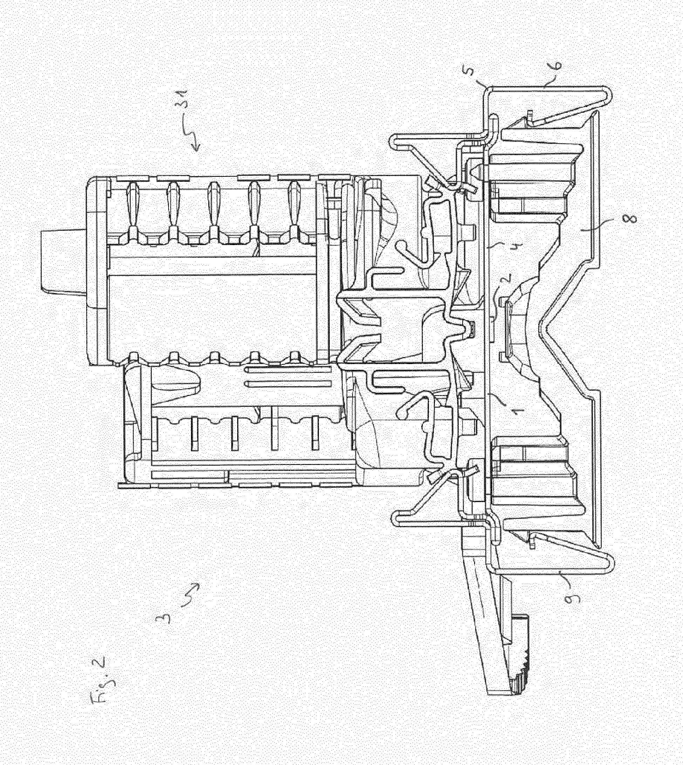

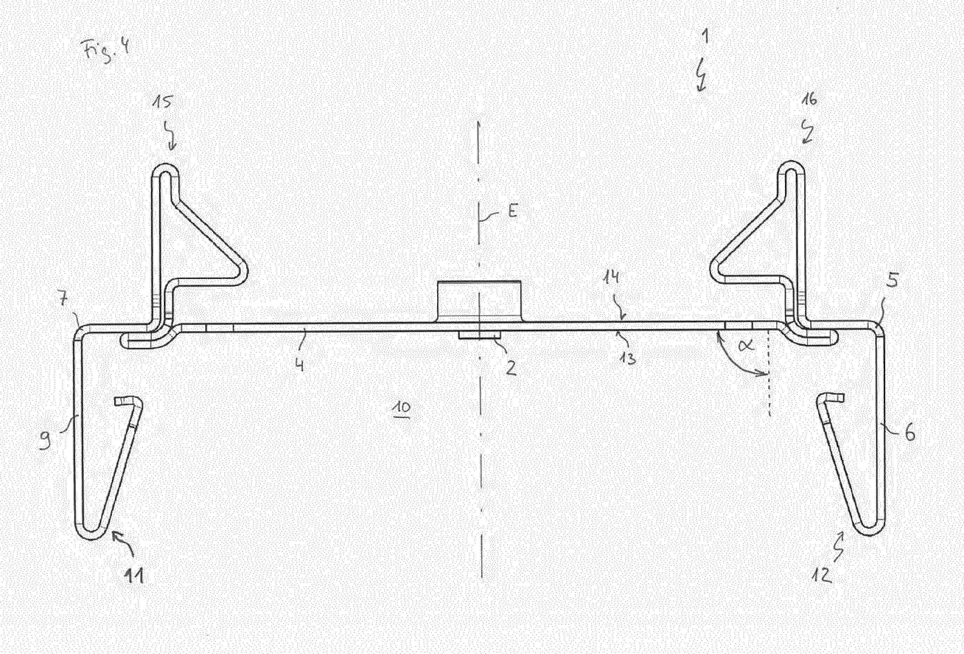

Fig. 2 zeigt eine Querschnitt-Skizze normal zu der Längsachse L. Die Leuchte weist eine Platine 1 mit wenigstens einer darauf angeordneten LED 2 auf, hier auch kurz als "LED-Platine" bezeichnet. In Fig. 4 ist die Platine 1 mit der darauf angeordneten LED 2 in separierter Form in einem entsprechenden Querschnitt skizziert.

Vorzugsweise ist die Platine 1 als profilartiges Bauteil gestaltet, so dass eine Profilachse P festgelegt ist, die vorzugsweise parallel zu der Längsachse L orientiert ist. Vorzugsweise sind mehrere LEDs 2 auf der Platine 1 angeordnet, insbesondere entlang einer zu der Längsachse L bzw. der Profilachse P parallelen Reihe. Außerdem kann die Leuchte 3 ein Betriebsgerät 32, insbesondere in Form eines Konverters oder Treibers aufweisen, das zur Bereitstellung eines elektrischen Stroms für eine Stromversorgung der wenigstens eine LED 2 dient.

Die Platine 1 weist eine, aus einem Blech gebildete Lage auf. Die Lage weist dabei einen ersten planen Bereich 4 und einen formbeständig gebogenen Bereich 5 auf. Mit "formbeständig gebogen" sei dabei zum Ausdruck gebracht, dass der betreffende Bereich 5 eine vorgesehene gebogene Form aufweist und dabei derart eigenstabil gebogen ist, dass diese Form beibehalten wird, wenn keine äußere Kraft auf ihn einwirkt bzw. lediglich die Schwerkraft. Insbesondere weist der gebogene Bereich ein elastisches Verhalten auf, so dass nach Beendigung einer auslenkenden Kraft die vorgesehene gebogene Form wieder selbstständig eingenommen wird.

Vorzugsweise ist die Gestaltung derart, dass die Platine 1 überwiegend aus der Lage besteht. Insbesondere kann durch die Lage ein formbildendes Gerüst, besonders bevorzugt das einzige formbildende Gerüst der Platine 1 gebildet sein. Die Platine 1 soll aus der Lage und wenigstens einer darauf angeordneter Schicht bestehen, die zur Bildung einer Leiterbahn der Platine dient und eine Lackschicht darstellt. Hierauf wird im Folgenden noch genauer eingegangen.

Insbesondere ist die mechanische Stabilität der Lage derart gewählt, dass sich dadurch die Platine 1 als tragendes Bauteil der Leuchte 3, insbesondere als Gehäuse der Leuchte 3, kurz Leuchtengehäuse, eignet. Insbesondere ist auch der plane Bereich 4 entsprechend stabil gestaltet. Beim gezeigten Beispiel ist durch die Platine 1 ein Gehäuse der Leuchte 3 gebildet.

Beispielsweise kann vorgesehen sein, dass die Lage aus einem Aluminiumblech oder einem Stahlblech oder einem Kupferblech besteht. Beispielsweise kann vorgesehen sein, dass die Dicke der Lage wenigsten 0,5 mm beträgt, besonders bevorzugt wenigstens 1 mm.

Vorzugsweise ist der gebogene Bereich 5 - wie im gezeigten Beispiel der Fall - um eine parallel zu der Profilachse P orientierte Biegeachse gebogen.

Insbesondere ist die Gestaltung derart, dass die Lage den ersten planen Bereich 4 und den gebogenen Bereich 5 in zusammenhängender Form bildend ausgestaltet ist.

Vorzugsweise weist der gebogene Bereich 5 einen Krümmungsradius auf, der kleiner als 10 mm ist, besonders bevorzugt kleiner als 5 mm, wobei der gebogene Bereich 5 insbesondere derart gestaltet ist, dass durch ihn - wie beispielhaft in Fig. 4 skizziert - eine Kante gebildet ist.

Wie beim gezeigten Beispiel der Fall, weist die Lage vorzugsweise außerdem einen zweiten planen Bereich 6 auf, der mit Bezug auf den gebogenen Bereich 5 dem ersten planen Bereich 4 gegenüberliegend angeordnet ist. Dabei ist der zweite plane Bereich 6 vorzugsweise gleich groß oder kleiner als der erste plane Bereich 4, jedoch mindestens so groß wie 10%, besonders bevorzugt 20% des ersten planen Bereichs 4. Wie beispielsweise aus Fig. 1 hervorgeht, erstreckt sich beim gezeigten Beispiel der zweite plane Bereich 6 durch einen Teil der Platine 1, der einen Außenflächenbereich der Leuchte 3 bildet. Das ist vorteilhaft, weil hierdurch eine, beim Betrieb der LED 2 erzeugte Wärme besonders effektiv in einen Umgebungsbereich bzw. Außenbereich der Leuchte 3 abgegeben werden kann.

Wie in Fig. 4 angedeutet, begrenzen beim gezeigten Beispiel der erste plane Bereich 4 und der zweite plane Bereich 6 einen Winkel a, der etwa 90° beträgt. Allgemein ist vorzugsweise vorgesehen, dass dass der erste plane Bereich 4 und der zweite plane Bereich 6 einen Winkel α begrenzen, der größer als 40° und kleiner als 140° ist. So lässt sich einer der beiden planen Bereiche, hier der erste plane Bereich 4 als geeigneter Bereich zur geschützten Anordnung der LED 2 nutzen und der andere, hier der zweite plane Bereich 6 zur Gestaltung einer Außenfläche der Leuchte, über die eine besonders geeignete Wärmeabgabe ermöglicht ist.

Außerdem weist die Lage weiterhin vorzugsweise einen weiteren formbeständig gebogenen Bereich 7 auf, der mit Bezug auf den ersten planen Bereich 4 dem zuerst genannten formbeständig gebogenen Bereich 5 gegenüberliegend ausgebildet ist. Dabei ist die wenigstens eine LED 2 auf dem ersten planen Bereich 4 angeordnet. So lässt sich besonders geeignet ein geschützter Bereich für die LED 2 bilden.

Weiterhin vorzugsweise ist die Lage in einem Querschnitt normal zu der Profilachse P betrachtet mit Bezug auf eine - in Fig. 4 beispielhaft skizzierte - Mittelebene E zumindest im Wesentlichen symmetrisch gestaltet, wobei vorzugsweise die wenigstens eine LED 2 auf der Mittelebene E liegend angeordnet ist. Dies ist vorteilhaft mit Bezug auf die Gestaltung der Platine 1 als Leuchtengehäuse.

Weiterhin vorzugsweise weist die Lage außerdem einen dritten planen Bereich 9 auf, der insbesondere mit Bezug auf den weiteren formbeständig gebogenen Bereich 7 dem ersten planen Bereich 4 gegenüberliegend ausgebildet ist. Wie beim gezeigten Beispiel der Fall, kann die Gestaltung hierbei vorteilhaft derart sein, dass durch den ersten planen Bereich 4, den zweiten planen Bereich 6 und den dritten planen Bereich 9 in einem Querschnitt normal zu der Längsachse L oder Profilachse P betrachtet eine U-Form mit zwei U-Schenkeln und einem, die beiden U-Schenkel miteinander verbindenden Verbindungsschenkel gebildet ist, wobei durch den zweiten planen Bereich 6 und den dritten planen Bereich 9 die zwei U-Schenkel gebildet sind und durch den ersten planen Bereich 4 der Verbindungschenkel. So lässt sich durch die Platine 1 ein besonders geeigneter geschützter Innenbereich 10 zur Anordnung der LED 2 bilden und durch die beiden U-Schenkel zwei gegenüberliegende Außenbereiche der Leuchte für eine besonders effektive Wärmeabgabe. Beispielsweise lässt sich der dritte plane Bereich 9 mit Bezug auf die Mittelebene E symmetrisch zu dem zweiten planen Bereich 6 gestalten.

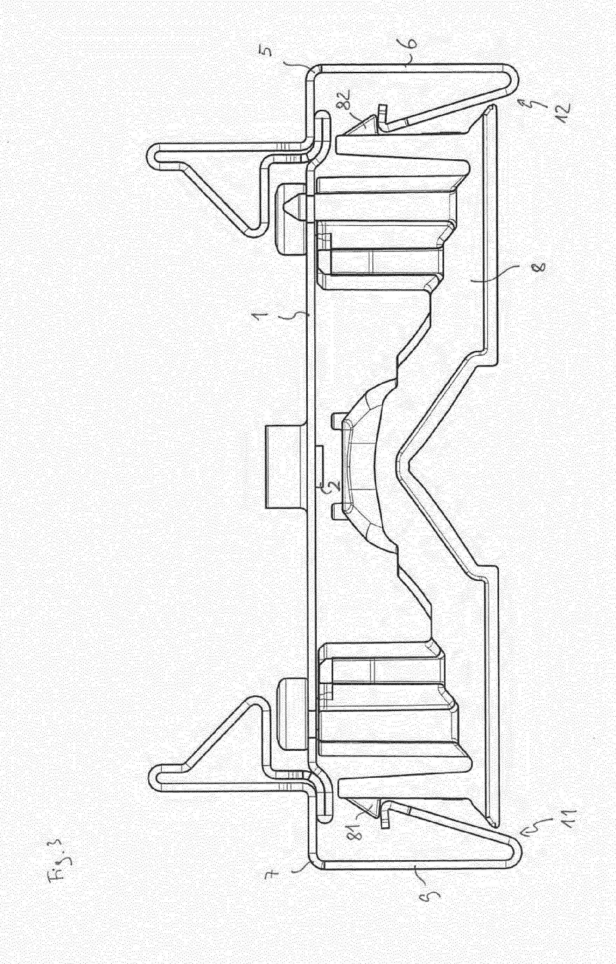

Wie beispielsweise aus Fig. 2 hervorgeht, weist die Leuchte beim gezeigten Beispiel weiterhin ein Lichtbeeinflussungselement 8 zur Beeinflussung eines von der wenigstens einen LED 2 abgestrahlten Lichts auf. Dabei ist das Lichtbeeinflussungselement 8 an der Platine 1 gehalten angeordnet. Vorzugsweise ist hierzu die Platine 1 derart gestaltet, dass sie Halteelemente 11, 12 aufweist, die zum Halten des Lichtbeeinflussungselements 8 ausgestaltet sind, insbesondere in Form von Rastelementen zur Erzeugung einer Rastverbindung, durch die das Lichtbeeinflussungselement 8 an der Platine 1 gehalten ist. In Fig. 3 ist die LED-Platine mit dem daran gehaltenen Lichtbeeinflussungselement 8 skizziert. Beispielsweise können die Halteelemente 11, 12 - wie skizziert - derart gestaltet sein, dass sie jeweils einen V-förmigen Querschnitt aufweisen. Das Lichtbeeinflussungselement 8 kann hierzu zwei entsprechende Rastnasen 81, 82 aufweisen. Durch diese Gestaltung ist eine besonders einfache Montage des Lichtbeeinflussungselements 8 an der Platine 1 ermöglicht. Vorteilhaft können die Halteelemente 11, 12 durch Fortsetzungen des zweiten planen Bereichs 6 und des dritten planen Bereichs 9 gebildet sein.

Beim gezeigten Beispiel erstreckt sich der erste plane Bereich 4 der Platine 1 durch einen Platinen-Bereich, der zwei gegenüberliegende Oberflächenbereiche aufweist, einen ersten Oberflächenbereich 13 und einen zweiten Oberflächenbereich 14, wobei die wenigstens eine LED 2 auf dem ersten Oberflächenbereich 13 angeordnet ist. Beim gezeigten Beispiel ist die Leuchte 3 dafür vorgesehen, zum Betrieb derart ausgerichtet zu werden, dass der erste Oberflächenbereich 13 nach unten weist und der zweite Oberflächenbereich 14 nach oben. Dabei ist die Gestaltung derart, dass die Leuchte 3 das von der LED 2 erzeugte Licht nach unten abgibt. Die Leuchte 3 eignet sich dementsprechend insbesondere als Deckenleuchte. Auch die beiden U-Schenkel weisen bei dieser Ausrichtung der Platine 1 nach unten.

Wie aus Fig. 1 in Verbindung mit Fig. 2 hervorgeht, kann die Leuchte 3 weiterhin derart gestaltet sein, dass das Betriebsgerät 32 mit Bezug auf den ersten planen Bereich 4 der wenigstens einen LED 2 gegenüberliegend angeordnet ist, insbesondere auf dem zweiten Oberflächenbereich 14 der Platine 1, also bei der hier betrachteten Ausrichtung auf der "Oberseite" des Platinen-Bereichs, durch den sich der erste plane Bereich 4 der Lage erstreckt. Auch der Rotationsabgriff 31 kann auf dem zweiten Oberflächenbereich 14 angeordnet sein. Weiterhin kann die Leuchte 3 auf dem zweiten Oberflächenbereich 14 beispielsweise einen Kabelhalter 33 und/oder eine Anschlussklemme für ein Kabel aufweisen, das beispielsweise zur Stromversorgung der LED 2 vorgesehen ist.

Wie aus Fig. 1 zu erkennen, besteht die Leuchte überwiegend aus der Platine 1.

Weiterhin kann die Platine 1 derart gestaltet sein, dass sie zwei Verbindungsstrukturen 15, 16 aufweist, die zur Halterung der Leuchte 3 an der oben erwähnten Tragschiene vorgesehen sind.

Weiterhin kann vorgesehen sein, dass an den beiden, durch die Profilachse P festgelegten Endbereichen der Platine 1 (in den Figuren nicht gezeigte) Stirnteile angeordnet sind bzw. werden.

Im gezeigten Beispiel stellt die Platine 1 mithin einen integralen Bestandteil eines tragenden Teils der Leuchte 3 bzw. eines Gehäuses der Leuchte 3 dar. Die Platine 1 ist derart ausgeführt, dass sie auf zwei gegenüberliegenden Seiten profilierte Bereiche aufweist, die einerseits der Befestigung an der Tragschiene dienen und andererseits der Halterung des Lichtbeeinflussungselements 8. Die profilierten Bereiche der Platine 1 umfassen also zum einen die Verbindungsstrukturen 15, 16 zur Halterung der Leuchte 3 an der Tragschiene und zum anderen die Halteelemente 11, 12 zur Erzeugung der Rastverbindung zur Halterung des Lichtbeeinflussungselements 8. Die profilierten Bereiche sind dabei vorzugsweise jeweils durch mehrere Biegungen der Lage gebildet, die jeweils um parallel zur Profilachse P orientierte Biegeachsen gebogen sind.

Zur Herstellung der Platine 1 ist vorzugsweise ein Verfahren vorgesehen, das die folgenden Schritte aufweist: a) Abwickeln eines, auf einer Rolle aufgewickelten Halbzeugs, das eine aus einem Blech gebildete Lage aus Metall aufweist, insbesondere aus einem Aluminiumblech, einem Stahlblech oder einem Kupferblech, b) Erzeugen eines formbeständig gebogenen Bereichs 5 der Lage durch ein Biegen des Halbzeugs, c) Schneiden des Halbzeugs zur Bildung eines Profilelements und d) Befestigen wenigstens einer LED 2 auf einer Oberfläche 13 des Profilelements. Dabei ist insbesondere die folgende Reihenfolge vorgesehen: a), b), c), d).

Im Schritt a) kann insbesondere das auf einer Rolle aufgewickelte Halbzeug in Form eines Coils vorgesehen sein. Als Halbzeug kann dabei insbesondere ein Blech vorgesehen sein, das eine Lackschicht aufweist, zum Beispiel eine einseitige Lackschicht oder beidseitige Lackschichten. Die Lackschicht bzw. eine der beiden Lackschichten kann dabei vorteilhaft zur Bildung einer Außenfläche der Leuchte 3 dienen. Dies ist insbesondere vorteilhaft mit Bezug auf eine effektive Wärmeabgabe bzw. Wärmeabstrahlung an die Umgebung. Außerdem kann sie vorteilhaft als Dielektrikum zur Bildung einer Leiterbahn der Platine 1 verwendet werden.

Weiterhin kann vorteilhaft vorgesehen sein, dass das Coil abgerollt wird und in der Horizontalen in einer Fertigungsstraße zur Erzeugung des Leuchtengehäuses behandelt bzw. bearbeitet wird, insbesondere durch Stanzen und/oder Prägen und/oder das Bilden von Sicken und/oder Walzen. So lässt sich besonders geeignet die Stabilität und die oben beschriebene gewünschte, vorgesehene Form der Platine 1 erzeugen. Im Weiteren kann vorgesehen sein, dass das so behandelte Halbzeug abgeschnitten wird, so dass Profilelemente gebildet werden, die sozusagen "Leuchtenstücke" darstellen.

Vorzugsweise weist das Verfahren außerdem den folgenden Schritt auf: e) Bilden einer Leiterbahn der Platine 1, wobei der Schritt e) entweder vor dem Schritt a) erfolgt oder zwischen den Schritten a) und b) oder zwischen den Schritten b) und d). Dabei wird im Schritt d) die LED 2 außerdem elektrisch mit der Leiterbahn verbunden, insbesondere unter Nutzung eines Lötofens. Dabei kann vorgesehen sein, dass die durch das im Schritt c) erfolgte Schneiden gebildeten "Leuchtenstücke" in einem Batch-Prozess dem Lötofen zugeführt und dort mit der wenigstens einen LED 2 bestückt werden.

Selbstverständlich kann eine Herstellung einer Leuchte vorgesehen sein, die ein anmeldungsgemäßes Verfahren zur Herstellung der Platine 1 umfasst. Auf diese Weise ist ein besonders vorteilhaftes Herstellungsverfahren für die Leuchte 3 ermöglicht.

Die fertig bestückten Platinen können dabei anschließend einer Endmontage zugeführt werden, in der gegebenenfalls das Lichtbeeinflussungselement 8, das Betriebsgerät 32, der Rotationsabgriff 31, der Kabelhalter 33, die Stirnteile und/oder die Anschlussklemme montiert werden. Außerdem können im Rahmen der Endmontage elektrische Verbindungen gesteckt werden.

Beispielsweise kann zur Bildung der Leiterbahn vorgesehen sein, dass auf ein geformtes und abgeschnittenes Halbzeug bzw. ein Leuchtenstück eine Platinenfolie auflaminiert wird. Die Platinenfolie kann derart gestaltet sein, dass sie ein Dielektrikum, die Leiterbahn und einen Lötstopplack ausbildet.

Es kann vorgesehen sein, dass ein Teilbereich der Platine 1, beispielsweise der zweite plane Bereich 6 der Lage nicht mit einer Leiterbahn versehen wird.

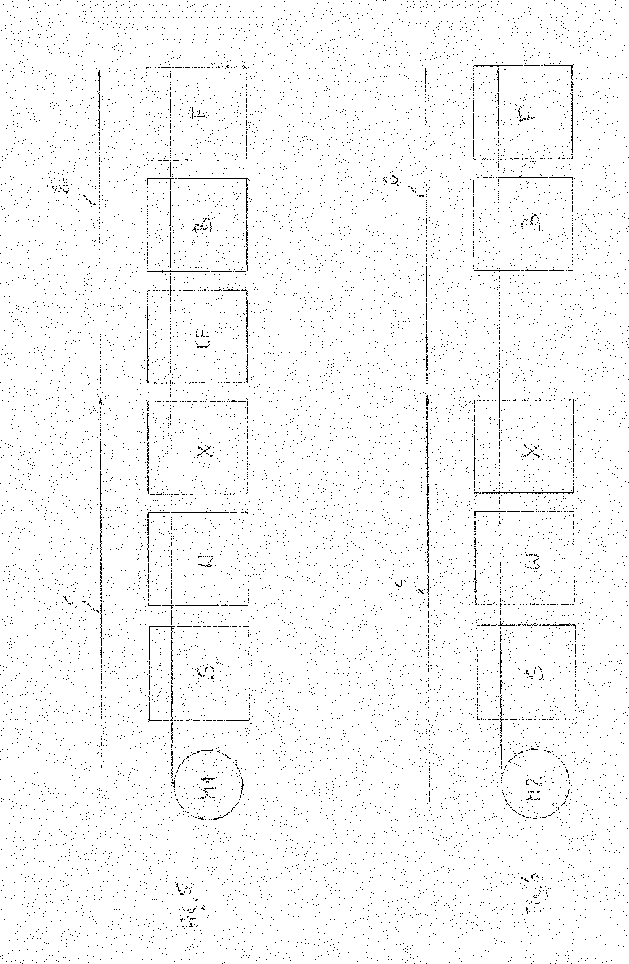

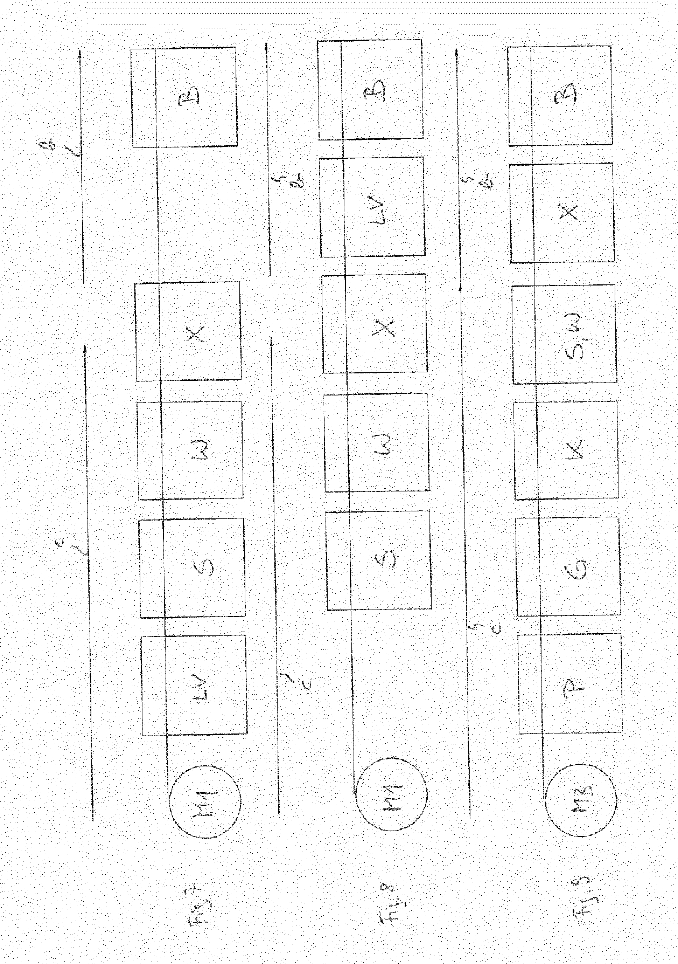

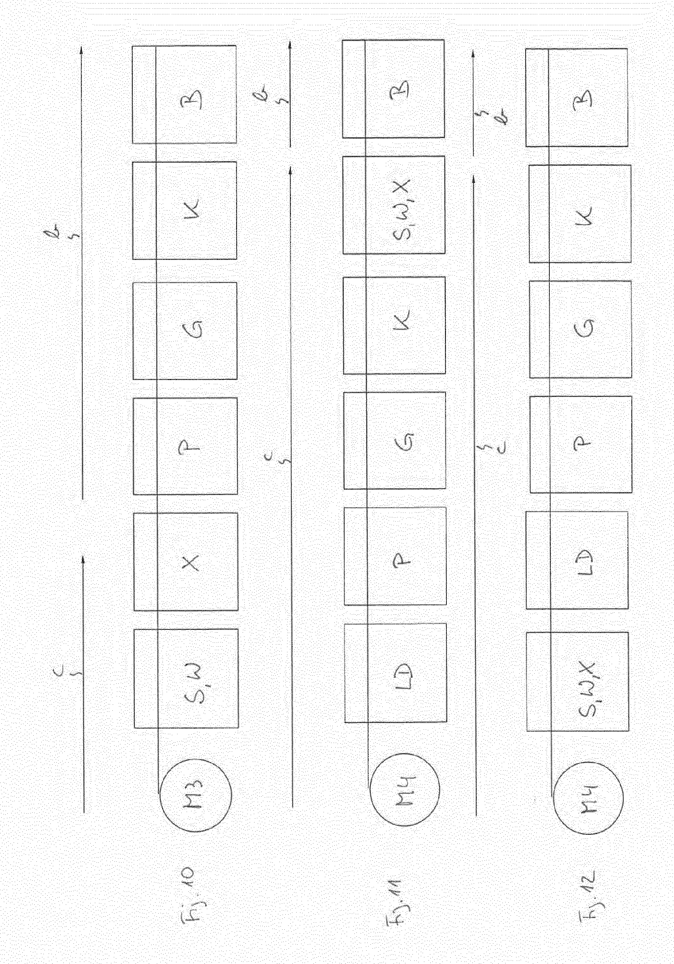

In den Figuren 5 bis 12 sind Skizzen zu möglichen Abläufen bei einem anmeldungsgemäßen Verfahren, das nicht Teil der Erfindung ist, gezeigt. Dabei bedeuten die rechteckigen Kästchen Verfahrensschritte, wobei die zeitliche Abfolge von links nach rechts gezeigt ist. Ausgangspunkt ist jeweils - wie durch einen Kreis symbolisiert ein Metall-Coil. Die über den Kästchen gezeigten Pfeile c verweisen auf einen kontinuierlichen Prozessabschnitt, die Pfeile b auf einen Prozessabschnitt in einem Batch-Betrieb.

Die in den Kreisen bzw. Kästchen angegebenen Buchstaben bzw. Buchstabenkombinationen haben dabei folgende Bedeutung:
M1: Metall-Coil, ein- oder beidseitig vorlackiert
M2: Metall-Coil, komplett vorkonfektioniert
M3: Metall-Coil, mit Metall - Dielektrikum - homogene Kupferschicht, Rückseite evtl. vorlackiert
M4: Metall-Coil, mit ein- oder beidseitig auflaminierter Folie
S: Stanzen / Prägen
W: Walzen / Profilieren
X: Schneiden
LF: Auflaminierung: Flexplatine (unbestückte Leiterbahnen inklusive Dielektrikum und Lötstopplack)
B: Bestückung im Lötofen
F: Leuchtenfertigung
LV: Auflaminieren vorkonfektionierte Leiterbahnfolie
P: Fotolack Layout, z. B. Siebdruck Walze
G: Belichtung, Ätzbad
K: Lötstopplack
LD: Auflaminieren zweier Folien: Dielektrikum und Kupfer oder einer Verbundfolie, z. B. Polyamid / Kupfer (Polyamid größer als Kupfer)

Bei dem Ätzbad kann dabei beispielsweise Eisen(III)-chlorid, Natriumsulfat oder Ammoniumpersulfat verwendet werden.

Darüber hinaus kann das Schneiden nach der Bestückung vorgesehen sein, z. B. mit Hilfe eines fahrbaren Lötofens oder einer getakteten Fertigungsstraße.

Mit einer anmeldungsgemäßen LED-Platine bzw. einer anmeldungsgemäßen Leuchte bzw. einem anmeldungsgemäßen Verfahren lassen sich insbesondere die folgenden Vorteile erzielen:
- Die Platine bildet das Gehäuse der Leuchte.
- Das durch die Patine gebildete Gehäuse der Leuchte kann die betriebsbedingte, von der LED erzeugte Wärme besonders gut ableiten.
- Die Platine bildet Befestigungselemente aus, beispielsweise durch Stanzungen oder Sicken, an denen Leuchtenteile befestigt werden können, z. B. Anschlussklemmen, Treiber, Akkus, Stirnteile.
- Das Metall-Coil erlaubt eine besonders kostengünstige Herstellung der Leuchte.
- Im Unterschied zum bisherigen Stand der Technik fällt eine Platine als Extrateil und somit eine Befestigung derselben weg.
- Der Wärmeübergang von der LED zum Gehäuse lässt sich quasi ideal gestalten - reine Wärmeleitung innerhalb des Materials.
- Die Rückseite der Platine muss wegen der Anbindung zum Gehäuse nicht ideal glatt sein für einen guten Wärmeübergang.
- Lackierte Flächen des Gehäuses bzw. der Platine strahlen die Wärme gut ab.
- Die Platine kann als Kühlkörper fungieren.
- Es kann vorlackiertes Blech verwendet werden, so ist keine anschließende Lackierung bzw. Beschichtung notwendig.

## Patentansprüche

1. Leuchte (3) mit einer Platine (1) mit wenigstens einer darauf angeordneten LED (2) sowie einem Lichtbeeinflussungselement (8) zur Beeinflussung eines von der wenigstens einen LED (2) abgestrahlten Lichts,
wobei die Platine (1) eine, aus einem Blech gebildete Lage aufweist, insbesondere aus einem Aluminiumblech, einem Stahlblech oder einem Kupferblech,
wobei die Lage einen ersten planen Bereich (4) und einen formbeständig gebogenen Bereich (5) aufweist,
wobei die Platine (1) aus der Lage und wenigstens einer darauf angeordneten Schicht besteht, die zur Bildung einer Leiterbahn der Platine (1) dient und eine Lackschicht darstellt,
und wobei die Platine (1) derart ausgeführt ist, dass sie auf zwei gegenüberliegenden Seiten profilierte Bereiche aufweist, die einerseits der Befestigung an einer Tragschiene dienen und andererseits der Halterung des Lichtbeeinflussungselements (8), so dass das Lichtbeeinflussungselement (8) an der Platine (1) gehalten angeordnet ist.

2. Leuchte nach Anspruch 1,
**dadurch gekennzeichnet,**
**dass** die Lage den ersten planen Bereich (4) und den gebogenen Bereich (5) in zusammenhängender Form bildend ausgestaltet ist.

3. Leuchte nach Anspruch 1 oder 2,
**dadurch gekennzeichnet,**
**dass** der gebogene Bereich (5) einen Krümmungsradius aufweist, der kleiner als 10 mm ist, vorzugsweise kleiner als 5 mm, wobei der gebogene Bereich (5) insbesondere derart gestaltet ist, dass durch ihn eine Kante gebildet ist.

4. Leuchte nach einem der vorhergehenden Ansprüche,
**dadurch gekennzeichnet,**
**dass** die Lage weiterhin einen zweiten planen Bereich (6) aufweist, der mit Bezug auf den gebogenen Bereich (5) dem ersten planen Bereich (4) gegenüberliegend angeordnet ist, wobei der zweite plane Bereich (6) gleich groß wie oder kleiner als der erste plane Bereich (4) ist, jedoch mindestens so groß ist wie 10%, vorzugsweise wie 20% des ersten planen Bereichs (4)
wobei vorzugsweise der erste plane Bereich (4) und der zweite plane Bereich (6) einen Winkel (α) begrenzen, der größer als 40° und kleiner als 140° ist.

5. Leuchte nach einem der vorhergehenden Ansprüche,
**dadurch gekennzeichnet,**
**dass** die Platine (1) zumindest im Wesentlichen ein profilförmiges Bauteil bildet, durch das eine Profilachse (P) festgelegt ist, wobei der gebogene Bereich (6) um eine parallel zu der Profilachse (P) orientiert Biegeachse gebogen ist
und wobei vorzugsweise die Lage weiterhin einen weiteren formbeständig gebogenen Bereich (7) aufweist, der mit Bezug auf den ersten planen Bereich (4) dem zuerst genannten formbeständig gebogenen Bereich (5) gegenüberliegend ausgebildet ist, wobei die wenigstens eine LED (2) auf dem ersten planen Bereich (4) angeordnet ist.

6. Leuchte nach Anspruch 5,
**dadurch gekennzeichnet,**
**dass** die Lage in einem Querschnitt normal zu der Profilachse (P) betrachtet mit Bezug auf eine Mittelebene (E) zumindest im Wesentlichen symmetrisch gestaltet ist, wobei vorzugsweise die wenigstens eine LED (2) auf der Mittelebene (E) liegend angeordnet ist.

7. Leuchte nach einem der vorherigen Ansprüche,
**dadurch gekennzeichnet,**
**dass** durch einen Oberflächenbereich der Platine (1) ein Außenflächenbereich der Leuchte gebildet ist.

8. Leuchte nach einem der vorherigen Ansprüche,
**dadurch gekennzeichnet,**
**dass** durch die Platine (1) ein Gehäuse der Leuchte gebildet ist.

## Claims

1. Lighting unit (3) having a circuit board (1) with at least one LED (2) arranged thereon and a light-influencing element (8) for influencing a light emitted by the at least one LED (2),
wherein the circuit board (1) has a layer formed from a metal sheet - in particular, from an aluminum sheet, a steel sheet, or a copper sheet,
wherein the layer has a first planar region (4) and a dimensionally-stable arcuate region (5),
wherein the circuit board (1) consists of the layer and at least one layer arranged thereon, which layer serves to form a conductor track of the circuit board (1) and represents a lacquer layer,
and wherein the circuit board (1) is designed in such a way that, on two opposite sides, it has profiled regions which serve, on the one hand, for attachment to a support rail and, on the other, for mounting the light-influencing element (8) so that the light-influencing element (8) is arranged to be held on the circuit board (1).

2. Lighting unit according to claim 1,
**characterized in that**
the layer is designed to form the first planar region (4) and the arcuate region (5) in a contiguous form.

3. Lighting unit according to claim 1 or 2,
**characterized in that**
the arcuate region (5) has a radius of curvature which is less than 10 mm, and preferably less than 5 mm, wherein the arcuate region (5) is designed, in particular, such that by means of it an edge is formed.

4. Lighting unit according to one of the preceding claims,
**characterized in that**
the layer further has a second planar region (6) which, with respect to the arcuate region (5), is arranged opposite the first planar region (4), wherein the second planar region (6) is the same size as or smaller than the first planar region (4), but at least as large as 10%, and preferably 20%, of the first planar region (4),
wherein, preferably, the first planar region (4) and the second planar region (6) form an angle (α) which is more than 40° and less than 140°.

5. Lighting unit according to one of the preceding claims,
**characterized in that**
the circuit board (1) at least essentially forms a profile-shaped component by means of which a profile axis (P) is defined, wherein the arcuate region (6) is curved about a bending axis oriented to be parallel to the profile axis (P),
and wherein the layer preferably further has an additional dimensionally-stable arcuate region (7) which, with respect to the first planar region (4), is formed opposite the first-mentioned dimensionally-stable arcuate region (5), wherein the at least one LED (2) is arranged on the first planar region (4).

6. Lighting unit according to claim 5,
**characterized in that**
the layer in a cross-section normal to the profile axis (P) with respect to a central plane (E) is designed to be at least essentially symmetrical, wherein the at least one LED (2) is preferably arranged so as to lie on the central plane (E).

7. Lighting unit according to one of the preceding claims,
**characterized in that**
an outer surface region of the lighting unit is formed by a surface region of the circuit board (1).

8. Lighting unit according to one of the preceding claims,
**characterized in that**
a housing of the lighting unit is formed by the circuit board (1).

## Revendications

1. Luminaire (3) comprenant une platine (1) sur laquelle est disposée au moins une DEL (2) ainsi qu'un élément influençant la lumière (8) pour influencer une lumière émise par ladite au moins une DEL (2),
la platine (1) présentant une couche formée d'une tôle, en particulier d'une tôle d'aluminium, d'une tôle d'acier ou d'une tôle de cuivre,
la couche présentant une première zone plane (4) et une zone incurvée indéformable (5),
la platine (1) étant constituée de la couche et d'au moins une strate disposée sur celle-ci, qui sert à former une piste conductrice de la platine (1) et qui représente une couche de vernis
et la platine (1) étant réalisée de telle sorte qu'elle présente des zones profilées sur deux côtés opposés, qui servent d'une part à la fixation sur un rail porteur et d'autre part au maintien de l'élément influençant la lumière (8), de sorte que l'élément influençant la lumière (8) est disposé en étant maintenu sur la platine (1).

2. Luminaire selon la revendication 1,
**caractérisé en ce que**
la couche est conçue en formant la première zone plane (4) et la zone incurvée (5) sous une forme cohérente.

3. Luminaire selon la revendication 1 ou 2,
**caractérisé en ce que**
la zone incurvée (5) présente un rayon de courbure inférieur à 10 mm, de préférence inférieur à 5 mm, la zone incurvée (5) étant conçue notamment de sorte à former une arête.

4. Luminaire selon l'une quelconque des revendications précédentes,
**caractérisé en ce que**
la couche présente en outre une deuxième zone plane (6), qui est disposée à l'opposé de la première zone plane (4) par rapport à la zone incurvée (5), la deuxième zone plane (6) étant de la même taille ou plus petite que la première zone plane (4), mais affichant au moins une taille équivalente à 10 %, de préférence à 20 % de la première zone plane (4),
la première zone plane (4) et la deuxième zone plane (6) délimitant de préférence un angle (a) supérieur à 40° et inférieur à 140°.

5. Luminaire selon l'une quelconque des revendications précédentes,
**caractérisé en ce que**
la platine (1) forme au moins essentiellement un composant profilé, à travers lequel un axe de profilé (P) est défini, la zone incurvée (5) étant incurvée autour d'un axe de courbure orienté parallèlement à l'axe de profilé (P)
et de préférence, la couche possédant en outre une zone incurvée indéformable (7) supplémentaire, qui est disposée à l'opposé de la zone incurvée indéformable susmentionnée (5) par rapport à la première zone plane (4), ladite au moins une DEL (2) étant disposée sur la première zone plane (4).

6. Luminaire selon la revendication 5,
**caractérisé en ce que**
la couche observée en coupe transversale normale par rapport à l'axe du profilé (P) est conçue de manière au moins essentiellement symétrique par rapport à un plan médian (E), ladite au moins une DEL (2) étant de préférence disposée de manière horizontale sur le plan médian (E).

7. Luminaire selon l'une quelconque des revendications précédentes,
**caractérisé en ce que**
une zone de surface extérieure du luminaire est formée par une zone de surface de la platine (1).

8. Luminaire selon l'une des revendications précédentes,
**caractérisé en ce que**
un corps du luminaire est formé par la platine (1).
